# EUROPEAN PATENT SPECIFICATION

(11) **EP 4 626 034 B1**
(45) Date of publication and mention of the grant of the patent: **02.09.2026**
(21) Application number: 24166248.5
(22) Date of filing: 26.03.2024
(51) Int. Cl.: H04R 19/00, H04R 19/02, H04R 19/04

(54) **MEMS STRUCTURE WITH A STRUCTURED TAPER LAYER**
MEMS-STRUKTUR MIT EINER STRUKTURIERTEN KEGELSCHICHT
STRUCTURE MEMS AVEC UNE COUCHE CONIQUE STRUCTURÉE

(43) Date of publication of application: 01.10.2025
(73) Proprietor: Infineon Technologies AG, 85579 Neubiberg (DE)
(72) Inventor: BASAVANNA, Abhiraj, 81739 München (DE); TIMME, Hans-Joerg, 85521 Ottobrunn (DE); FREY, Alexander, 93138 Lappersdorf (DE); FÜLDNER, Marc, 85579 Neubiberg (DE); TKACHUK, Konstantin, 82008 Unterhaching (DE)
(74) Representative: Hersina, Günter

(56) References cited:
- US-A1- 2012 248 554
- US-A1- 2019 255 669
- US-A1- 2021 139 319

## Description

### Technical Field

Embodiments of the present disclosure relate to a MEMS (Micro-Electro-Mechanical System) structure, such as a MEMS structure with a membrane structure and a first and second clamping structure. In particular, embodiments relate to a MEMS structure with a second clamping structure having a structured taper layer with a tapered edge region.

### Background

MEMS structures with membrane structures are used in various devices such as microphones, speakers, sensors, acoustic devices, audio devices, and environmental sensors. Commonly for such applications, the membrane structure needs to be deflected, which can cause mechanical strain and the risk of mechanical failure. Increasing a size or thickness of the membrane structure may improve the stability, but may also negatively affect performance.

When designing, for example, a microphone device, achieving both good performance and good robustness seems to be difficult, since straight forward approaches to achieve better performance may have negative effects on the robustness of the device. This is usually because a failure mode of a microphone can relate to multitude of issues, which may be amplified due to design decisions on achieving higher performance. Hence, achieving good robustness along with no performance lag is difficult if not un-achievable.

For example, due to new application areas such as True Wireless Stereo (TWS), new MEMS structures are required to help provide better features and performance. In order to provide a better microphone, the robustness and acoustic performance of the microphone may need to be improved. An exemplary robustness requirement for certain customers is a Distance Airblow Test (DAT), wherein, for example, pressures up to several bars are considered. For example, single back-plate designs may suffer from low DAT robustness.

Some further relevant prior art teaching may be found in: US 2012/248554 A1, US 2019/255669 A1 and US 2021/139319 A1.

Therefore, there is a need in the field of MEMS structures with membrane structures that offers an improved compromise between stability and performance.

Such a need can be solved by the MEMS structure according to the independent claims.

Further, specific implementations of the MEMS structure are defined in the dependent claims.

### Summary

According to an embodiment, a MEMS structure is provided. The MEMS structure comprises a back-plate structure, a support structure having a cavity, a membrane structure between the back-plate structure and the support structure, a first clamping structure having a first structured oxide layer between the support structure and the membrane structure, wherein an inner edge of the first clamping structure is laterally offset from an edge of the cavity, wherein the offset of the first clamping structure forms a gap between the support structure and the membrane structure, and a second clamping structure having a second structured oxide layer and a structured taper layer between the back-plate structure and the membrane structure, wherein the second structured oxide layer is arranged between the back-plate structure and the structured taper layer, and wherein an inner edge of the second structured oxide layer laterally extends over the cavity, and wherein the structured taper layer is arranged between the second structured oxide layer and the membrane structure and has a tapered edge region, which laterally extends beyond the edge of the second structured oxide layer on the membrane structure.

Further embodiments are described in the dependent claims.

Thus according to an embodiment, a second clamping structure is provided that extends laterally over the cavity, whereas a first clamping structure is provided that is laterally offset to form a gap between the support structure and the membrane structure. As a result, a region of the membrane structure not contacted by a clamping structure (and subsequently able to deflect) is primarily defined by the second clamping structure rather than the first clamping structure and/or the support structure. Furthermore, the second clamping structure can support the membrane structure on a larger area compared to the first clamping structure. Since the second clamping structure is arranged between the membrane structure and the back-plate structure, the second clamping structure provides improved support towards the back-plate structure. In other words, the MEMS structure allows the use of a full stack support (FSS), wherein, for example, a membrane radius (e.g., deflectable membrane region) may be defined by the second clamping structure (e.g., TEOS-1) rather than the cavity of the support structure (e.g., the radius defined by the DRIE/Bosch process used to create the cavity). The second clamping structure may subsequently improve a backside robustness (e.g., with a reduced risk of excessive deflection towards the back-side structure) compared to a support by a larger first clamping device on a support structure side of the membrane structure (e.g., since the contact between the membrane structure and the first clamping structure may form a stress hotspot since the entire membrane structure may be dependent on that point). The inner edge of the cavity may be located more laterally outside, which can reduce the risk of a contact between the support structure and the membrane structure during displacement or deflection of the membrane structure.

Furthermore, it has been recognized that the structured taper layer between the back-plate structure and the membrane structure synergizes with the second clamping structure to improve a front side robustness (e.g., with a reduced risk of excessive deflection towards the cavity or away from the back-side structure). For example, the tapered edge region may improve a local sturdiness and reduce force peaks, while still providing a flexibility for deflection. Therefore, a compromise between a back-side and front-side robustness can be improved. In other words, adding a taper on a region between the membrane structure and the second clamping structure may improve a robustness, as support of the membrane structure may be more dependent on a mechanical stability of a region including a membrane top (e.g., portion of the membrane structure facing the back-plate structure) and the second clamping structure.

In other words, the MEMS structure disclosed herein uses a modified membrane/back-plate stack with small design changes to remove (or lessen) critical stress hotspot areas without significant performance penalty. The MEMS structure may require introduction of one (or more) extra layers and may be compatible with currently widely available fabrication methods that can be used to reach the aforementioned requirements. For example, the MEMS structure may be realized with a thinner membrane structure, due to the improved mechanical stability.

### Brief Description of the Figures

In the following, embodiments of the present disclosure are described in more detail with respect to the figures, in which:
- Fig. 1: shows a cross-sectional view of an example of a MEMS structure;
- Fig. 2a: shows a schematic top view of an example of a MEMS structure with a lateral extension having a rectangular shape;
- Fig. 2b: shows a schematic top view of an example of a MEMS structure with a lateral extension having a circular shape;
- Fig. 2c: shows a schematic top view of an example of a MEMS structure with a rectangular membrane structure, wherein a second clamping structure has two portions;
- Fig. 2d: shows a schematic top view of an example of a MEMS structure with a circular membrane structure, wherein the second clamping structure has two portions;
- Fig. 3: shows a table with exemplary parameters for components of the MEMS structure;
- Fig. 4: shows a schematic cross-section of an example of the tapered edge region;
- Fig. 5: shows a schematic cross-section of another example of a MEMS structure;
- Fig. 6: shows a schematic cross-section of another example of a MEMS structure;
- Fig. 7: shows a schematic cross section of another example of a MEMS structure;
- Fig. 8: shows a schematic cross section of another example of a MEMS structure;
- Fig. 9: shows a schematic cross section of another example of a MEMS structure; and
- Fig. 10: shows a schematic cross section of another example of a MEMS structure.

In the following description, embodiments are discussed in further detail using the figures, wherein in the figures and the specification identical elements and elements having the same functionality and/or the same technical or physical effect are provided with the same reference numbers or are identified with the same name. Thus, the description of these elements and of the functionality thereof as illustrated in the different embodiments are mutually exchangeable or may be applied to one another in the different embodiments.

### Detailed Description of the Figures

In the following description, embodiments are discussed in detail, however, it should be appreciated that the embodiments provide many applicable concepts that can be embodied in a wide variety of semiconductor devices. The specific embodiments discussed are merely illustrative of specific ways to make and use the present concept, and do not limit the scope of the embodiments. In the following description of embodiments, the same or similar elements having the same function have associated therewith the same reference signs or the same name, and a description of such elements will not be repeated for every embodiment.

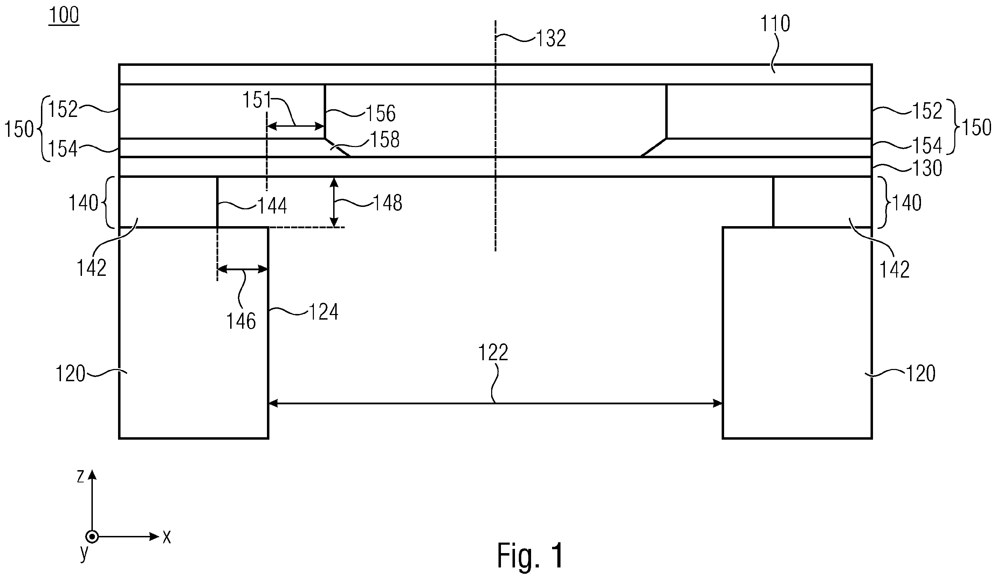

For facilitating the description of the different embodiments, some of the figures comprise a Cartesian coordinate system x, y, z, wherein the x-y-plane corresponds, i.e. is parallel, to a main surface region (e.g. a displaceable or deflectable structure) of a (suspended) MEMS membrane (= a reference plane = x-y-plane), wherein the direction vertically up with respect to the reference plane (x-y-plane) corresponds to the "+z" direction, and wherein the direction vertically down with respect to the reference plane (x-y-plane) corresponds to the "-z" direction. In the following description, the term "lateral" means a direction parallel to the x- and/or y-direction or a direction parallel to (or in) the x-y-plane, wherein the term "vertical" means a direction parallel to the z-direction. For example, in the context of MEMS structures, which may be fabricated using material deposition to grow layers of material, the lateral direction may define extension direction of grown layers (or a surface of a substrate on which the layers are grown), whereas the vertical direction may define a direction perpendicular to the extension of the layers, or parallel to a grown direction, or perpendicular to a surface of the substrate on which the layers are grown. Fig. 1 shows a cross-sectional view of an example of a MEMS structure 100.

The MEMS structure 100 comprises a back-plate structure 110, a support structure 120 having a cavity 122, a membrane structure 130 between (e.g., in z-direction) the back-plate structure 110 and the support structure 120.

The MEMS structure 100 further comprises a first clamping structure 140 having a first structured oxide layer 142 between (e.g., in z-direction) the support structure 120 and the membrane structure 130, wherein an inner edge 144 of the first clamping structure 140 is laterally (e.g., in x-direction and/or y-direction) offset from an edge 124 of the cavity 120, wherein the offset 146 of the first clamping structure forms a gap 148 (e.g., in z-direction) between the support structure 120 and the membrane structure 130.

The MEMS structure 100 further comprises a second clamping structure 150 having a second structured oxide layer 152 and a structured taper layer 154 between (e.g., in z-direction) the back-plate structure 110 and the membrane structure 130.

The second structured oxide layer 152 is arranged between (e.g., in z-direction) the back-plate structure 110 and the structured taper layer 154, and wherein an inner edge 156 of the second structured oxide layer 152 laterally (e.g., in x-direction and/or y-direction) extends over the cavity 122.

The structured taper layer 154 is arranged between (e.g., in z-direction) the second structured oxide layer 152 and the membrane structure 130 and has a tapered edge region 158, which laterally (e.g., in x-direction and/or y-direction) extends beyond the edge 156 of the second structured oxide layer 152 on the membrane structure 130.

It is noted that Fig. 1 shows a cross-sectional view with first and second clamping structures 140, 150 on a left and right side. Such a cross-sectional view may, for example, be obtained from a MEMS structure 100 in which the membrane structure 130 is clamped only on two opposite sides thereof. For example, the MEMS structure 100 may be realized by extending the cross-section shown in Fig. 1 along a straight line in the y-direction (e.g., forming a bridge-like structure, e.g., the membrane structure 130 forming a beam supported by parts of the first and second clamping structures on two opposite sides of the membrane structure 130). However, in a different example, the cross-section shown in Fig. 1 may show a cross-section through a circularly or elliptically shaped MEMS structure (e.g., when viewed from above, e.g., when viewed along the z-direction). For example, in the case of a circularly shaped MEMS structure 100, the MEMS structure 100 may be realized by rotating the cross-section shown in fig. 1 around a central axis (e.g., central axis 132).

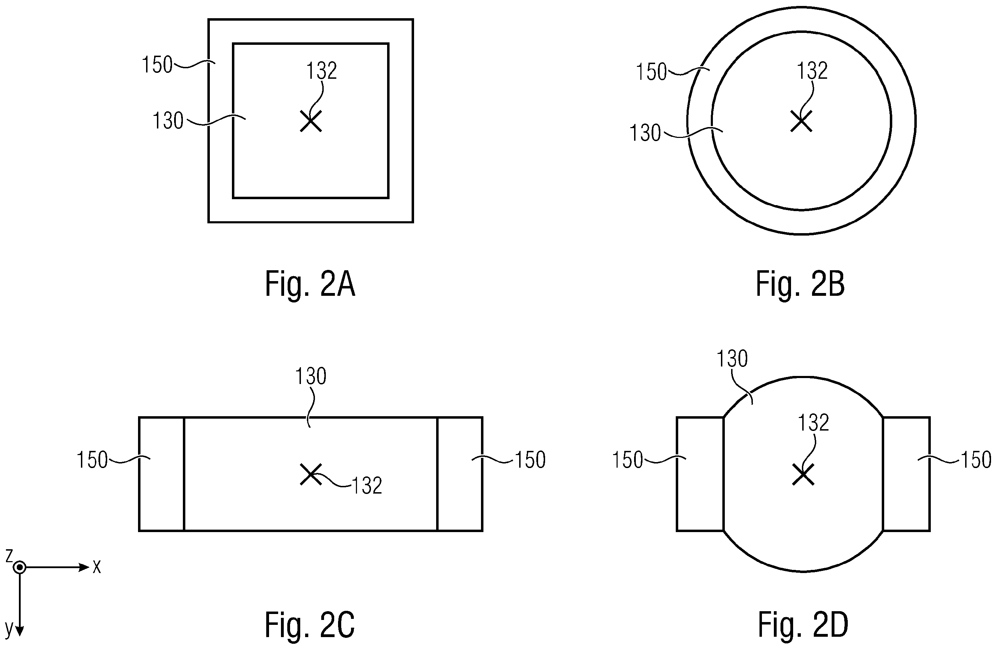

Fig. 2a-d show a schematic top view of examples of MEMS structures 100 with different lateral extensions or shapes. In Fig. 2a-d, a back-plate has been omitted in the drawings, in order to better visualize the membrane structure 130 relative to the second clamping structure 150. A first clamping structure and/or support structure (both not shown in fig. 2a-d) may be arranged similarly (or differently) relative to the membrane structure 130 as the second clamping structure 150.

Fig. 2a shows a schematic top view of an example of a MEMS structure with a lateral extension having a rectangular shape. The second (and/or first) clamping structure 150 may extend along an entire perimeter of (or fully clamp) the membrane structure 130. In such a case, the second (and/or first) clamping structure 150 may form a single continuous structure. The lateral extension of the MEMS structure 100 (or the membrane structure 130 or any of the clamping structures 140/150) may have a rectangular, square or polygonal shape.

Fig. 2b shows a schematic top view of an example of a MEMS structure with a lateral extension having a circular shape. Similar to the example shown in Fig. 2a, the second (and/or first) clamping structure 150 of fig. 2b may extend along an entire perimeter of (or entirely clamp) the membrane structure 130. The lateral extension of the MEMS structure (or the membrane structure 130 or any of the clamping structures 140/150) may have a circular or elliptical shape.

While the examples shown in fig. 2a, b depict the second (and/or first) clamping structure 150 as a single continuous structure, the second (and/or first) clamping structure 150 may comprise a plurality of portions (e.g., two, three, four, or more) that are spatially separate from each other (e.g., in form of a free-floating membrane). For example, the MEMS structure 100 shown in fig. 2a may only have second (and/or first) clamping structure 150 along (e.g., portions of) the straight edges of the membrane structure 130, but not at its corners. As a result, the MEMS structure 100 may have four clamping structure portions (or more or less than four portions).

Fig. 2c shows a schematic top view of an example of a MEMS structure with a rectangular membrane structure 130, wherein the second (and/or first) clamping structure 150 has two portions.

Fig. 2d shows a schematic top view of an example of a MEMS structure with a circular membrane structure 130, wherein the second (and/or first) clamping structure 150 has two portions.

Fig. 2a-d show a central axis 132 of the membrane structure 130. The central axis 132 may be defined by a geometric centre or symmetry centre of the membrane structure 130 (and/or of the cavity 122). The central axis 132 may arranged a point of maximum deflectability of the membrane structure 130. As can be seen in Fig. 2a-d , the second (and/or first) clamping structure 150 at least partially surrounds or frames the central axis 132. An inward lateral direction may be defined as facing at least partially towards the central axis 132. An outward direction may be defined as facing at least partially away from the central axis 132. For example, an inward lateral direction may be defined as facing the central axis 132 (e.g., in the case of a circular membrane) or as facing predominately towards the central axis 132. For example, an inward lateral direction may be defined as perpendicular to an peripheral edge of the membrane structure 130 and oriented towards a deflectable region of the membrane structure 130. For example, in the case of the membrane structure 100 of fig. 2a, a laterally inward direction may be parallel to the y-direction for the upper and lower edge of the membrane structure 130 and parallel to the x-direction for the left and right edge of the membrane structure 130. For example, in the case of the membrane structure 100 of fig. 2b, a lateral inward direction may be defined as a radial direction from an edge of the membrane structure 130 to the central axis 132.

One or more of the back-plate structure 110, the support structure 120, the membrane structure 130, the first clamping structure 140, the second structure 150, and any layer of the aforementioned components may comprise or be formed by at least a part of a planar (e.g., flat) layer. Such a layer may be grown by any semiconductor process such as vacuum deposition (e.g., thermal evaporation, sputtering, chemical vapour deposition, or physical vapour deposition). Any such a layer may be structured by using one or more processes of optical lithography, etching (e.g., dry or wet etching), deposition of a sacrificial layer and removal (e.g., etching) of a deposition layer. However, one or more of back-plate structure 110, the support structure 120, the membrane structure 130, the first clamping structure 140, the second structure 150, and any layer of the aforementioned components may comprise or be formed by at least a part of a non-planar layer (e.g., a corrugated layer), e.g., the membrane structure 130 (or a layer thereof), as will be described further below.

In the example shown in Fig. 1, the back-plate structure 110, the support structure 120, the membrane structure 130, the first clamping structure 140, and the second structure 150 have a (common) laterally outside flush surface (e.g., on the very left and right side of fig. 1). However, one more or all of the aforementioned structures 110, 120, 130, 140, 150 may not be arranged flush with a structure or layer above and/or below thereof.

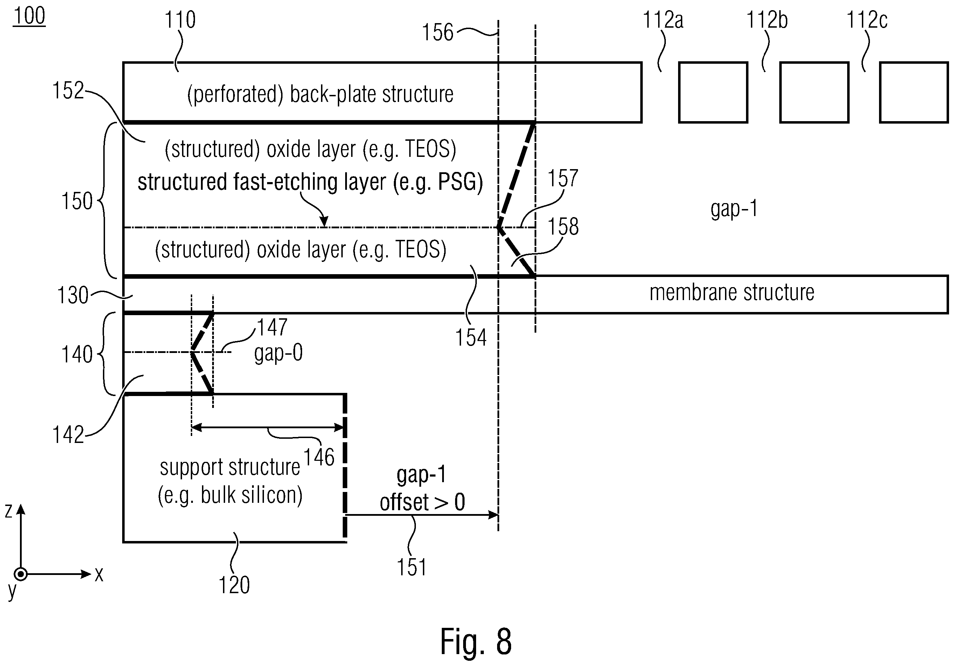

At least one of the support structure 120, the first clamping structure 140 (or one or more layers thereof such as the first structured oxide layer 142), and the second structured oxide layer 152 may have an inner lateral surface with a vertical extension. For example, at least one of the inner surfaces may have a rectangular flat surface (e.g., in case of a rectangular membrane structure 130 such as in Fig. 2a or 2b) or a round (e.g., cylindrical) surface (e.g., in the case of an elliptical or circular membrane structure 130 and/or the back-plate structure 110), e.g., with vertical surface lines). Alternatively, at least one inner surface of the support structure 120, the first clamping structure 140 (or one or more layers thereof such as the first structured oxide layer 142), and the second structured oxide layer 152 may have a convex or concave shape. The convex or concave shape may extend along a straight or curved line along at least a part of a perimeter of the membrane structure 130. At least one of the first and second structured oxide layer 142, 152 may have a tapering towards an intermediate layer, which will be discussed in more detail further below with reference to fig. 8 to 10.

In the case of a concave or convex inner surface, an edge (or inner edge) may be defined as a laterally most outer portion of the inner surface. For example, in the case of the first structured oxide layer 142 having a convex inner surface, wherein the inner surface tapers towards a notch, the inner edge of the first structured oxide layer 142 may be located at the notch. In the case of an laterally outer surface of the first structured oxide layer 142 that extends vertically (e.g., as schematically depicted in Fig. 1), the inner edge of the first structured oxide layer 142 may be located at a vertical position of the inner surface at which the first structured oxide layer 142 is the thinnest.

As has been discussed above, the MEMS structure 100 may show improved back-plate robustness. For example, test measurements have shown for some embodiments a stability for a Distance Airblow Test (DAT) of 6 bar. One of the advantages of the MEMS structure 100 is the DAT robustness may be improved with no or little changes in performance. An improved performed may affect, for example, a sound quality of captured or emitted sound of a microphone or audio speaker comprising the MEMS structure 100. Any MEMS structure 100 disclosed herein may be used in combination with various membrane types including capacitive and piezoelectric types. The MEMS structure 100 may also be used for other designs of single back plate (SBP) technology.

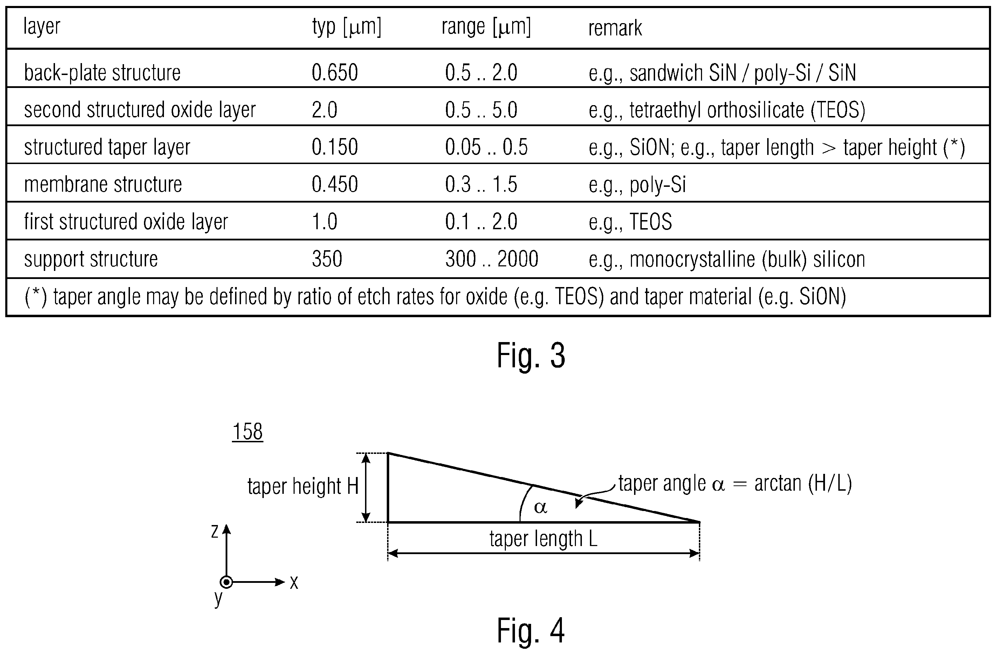

Fig. 3 shows a table with exemplary parameters for components of the MEMS structure 100. One or more (or all) parameter described with reference to fig. 3 may be used in combination with any MEMS structure 100 disclosed herein.

The back-plate structure 110 (e.g., black plate) may comprise one or more (e.g., circular) perforations. The perforations may not (or may) laterally extend over the tapered edge region 158. The back-plate structure 110 may have a thickness in a range of 0.5 µm to 2 µm, e.g., in a range of 0.6 µm to 0.7 µm, e.g., 0.650 µm. The back-plate structure 110 may comprise a semiconductor material such as silicon. The back-plate structure 110 may comprise or be formed by a sandwich structure with three layers. For example, the back-plate structure 110 may comprise or be formed by a lay of silicon mononitride, SiN, a layer of silicon (e.g., polycrystalline silicon), and a layer of SiN.

The MEMS structure 100 may be a sound transducer with a single back-plate 110. For example, the MEMS structure 110 may not comprise a further back-plate structure between the support structure 120 and the membrane structure 130. For example, no layer between the support structure 120 and the membrane structure 130 may extend into a lateral extension of the cavity 120. The sound transducer (or MEMS structure 100) may comprise or be part of a microphone and/or loudspeaker.

Alternatively, the MEMS structure 100 (or a device comprising the MEMS structure 100) may comprise two back-plate structures, e.g., a double back-plate. For example, the MEMS structure 100 may comprise a first back-plate structure (e.g., back-plate structure 110), a second back-plate structure, and a membrane structure (e.g., membrane structure 130) arranged between the first and second membrane structure.

The support structure 120 (e.g., support) may comprise or consist of a semiconductor material such as silicon (or a III-IV semiconductor) and/or an oxide thereof. For example, the support structure 120 may comprise or consist of silicon, e.g., monocrystalline silicon (or bulk silicon). The support structure 120 may have a thickness in a range of 300 µm to 2000 µm, e.g., in a range of 300 µm to 400 µm, e.g., 350 µm.

The support structure 120 may form a substrate for growing the remaining layers on top of it. The MEMS structure 100 may comprise a substrate (e.g., a silicon wafer or a printed circuit board), wherein the support structure 120 may be formed (e.g., grown) on or attached to the substrate, which may comprise an opening to the cavity 122.

The cavity 122 may be formed in the support structure 120 by an etching process such as a deep reactive-ion etching (DRIE) process (e.g., the so-called Bosch process). The cavity 122 may have a circular, elliptical, rectangular, square, or polygonal lateral extension. The cavity 122 may have an inner surface (e.g., a surface facing the central axis 132) that extends vertically.

The edge 124 of the cavity 122 may be arranged at the inner surface of the cavity 122. The edge 124 of the cavity 122 may be arranged at a most laterally outside portion of the inner surface of the cavity 122. The edge 124 of the cavity 122 may be arranged where the inner surface of the cavity 122 meets an upper surface of the support 120 that is facing the membrane structure 130 (e.g., at an upper and inner rim of the support structure 120).

The membrane structure 130 (e.g., membrane) may comprise or consist of a semiconductor material such as silicon (or a III-IV semiconductor) and/or an oxide thereof. For example, the membrane structure 130 may comprise or consist of polycrystalline silicon. The membrane structure 130 may have a thickness in a range of 0.1 µm to 5.0 µm, e.g., in a range of 0.3 µm and 1.5 µm, e.g., 0.450 µm.

The membrane structure 130 may have a (e.g., lateral) shape that is circular, elliptical, rectangular, square, or polygonal. In addition to such a shape, the membrane 130 may have structures to be clamped and/or electrically contacted. However, the membrane structure 130 may be clamped and/or electrically contacted without such structures.

The membrane structure 130 may comprise a membrane portion that forms a deflectable body and one or more further membrane components that are connected to or attached to the membrane portion. The one or more further membrane components may comprise at least one of one or more electrodes, a landing pad (as will be described further below), and a protrusion (as will be described further below).

The membrane structure 130 may comprises in a border region (e.g., which is not covered by the tapered edge region of the structured taper layer), which comprises a corrugation, which is directed to the support structure. The corrugation may comprise a plurality of ridges and grooves. For example, a cross section through the membrane structure 130 may have (e.g., periodic) wave pattern (e.g., a sinus pattern). A corrugation pattern (e.g., ridges and grooves thereof) may have a straight extension. For example, the membrane structure 130 may have a rectangular shape and be clamped at two opposite ends, wherein the corrugation pattern (e.g., ridges and grooves thereof) extends perpendicular to an extension direction between the two opposite ends of the membrane structure 130. Alternatively, the corrugation pattern (e.g., ridges and grooves thereof) may have a circular or oval shape. For example, the membrane structure 130 may have a circular shape wherein the corrugation pattern (e.g., ridges and grooves thereof) has a plurality of concentric circles.

The corrugation may extend towards the cavity 122. For example, the corrugations of the membrane structure 130 may be located (e.g., meandering) within a vertical range, wherein a back-plate structure 110 facing surface portion of the membrane structure 130 in a non-corrugated region of the membrane is arranged in an upper half or at an upper border of the vertical range. In other words, the corrugations may not have a vertical overlap with at least one of the second clamping structure 150, second structured oxide layer 152, and the structured taper layer 154.

Alternatively, the membrane structure 130 may be or comprise a flat planar layer. The membrane structure 130 may have a border region with a corrugation and a flat region separate from the border region (e.g., surrounding or being surrounded by the border region) which has a flat shape.

An exposed center region of the membrane structure 130 (e.g., not covered by the structured taper layer 154 or the tapered edge region 158, e.g., within the inner edge of the second structured oxide layer 152) may form a deflectable region of the membrane structure 130. For example, a portion of the membrane structure 130 that is laterally spanned between the structured taper layer 154 (or the tapered edge region 158 or inner edges 156 of the second structured oxide layer 152) may form a deflectable region. The second structured oxide layer 152 may be structured (e.g., due to its thickness and/or material) to be significantly less deformable than the membrane structure 130 so that a portion of the membrane structure 130 that is laterally outside of the structured taper layer 154 (or the tapered edge region 158 or inner edges 156 of the second structured oxide layer 152) is not (or not significantly) deformable. A portion of highest deformability of the membrane structure 130 may be located at or in a vicinity of the central axis 132. The deflectable region may define a membrane radius (e.g., in the case of a circularly shaped membrane structure 130) or a spanning distance (e.g., in the case of a bridge-design).

The first clamping structure 140 may be in direct contact with (e.g., attached to) at least one of the support structure 120 and the membrane structure 130. Alternatively, one or more layers may be arranged between the first clamping structure 140 and at least one of the support structure 120 and the membrane structure 130.

The first structured oxide layer 142 (e.g., oxide layer 0) may comprise or consist of an oxide of a semiconductor such as silicon (or a III-IV semiconductor). For example, the first structured oxide layer 142 may comprise or consist of silicon oxide, which may, for example be formed by a deposition using a precursor that comprises tetraethyl orthosilicate (TEOS). The first structured oxide layer 142 may have a thickness in a range of 0.05µm to 5.0µm, e.g., in a range of 0.1µm and 2.0µm, e.g., 1.0µm.

The lateral offset 146 of the first structured oxide layer 142 to the edge 124 of the cavity 122 may be less than 15 µm (or 10 µm) or may be in a range of 1µm to 30µm (e.g., between 1µm and 15 µm). The lateral offset 146 may be constant (e.g., within a tolerance of ±5% or ±1%) along a perimeter of the support structure 120 (e.g., along the y-direction in case of a square shaped membrane structure 130, e.g., along an angular direction in case of a circular shaped membrane structure 130).

A lateral extension of the cavity 122 (e.g., at an upper edge thereof) may be larger than a lateral extension of the deflectable portion of the membrane structure 130. The lateral extension may define a length extending perpendicular between two opposite edges. The lateral extension of the cavity 122 may define a diameter (e.g., in the case of a circular cavity 122) or a length of an edge (e.g. parallel to the y-direction, e.g., in the case of a rectangular shaped cavity 122) of the cavity 122. Similarly, lateral extension of the deflectable portion of the membrane structure 130 may define a diameter (e.g., in the case of a circular membrane structure 130) or a length of an edge (e.g. parallel to the y-direction, e.g., in the case of a rectangular membrane structure 130) of the membrane structure 130. The deflectable portion of the membrane structure 130 may be defined by a (central) region not covered by 158 tapered edge region 158 or not covered structured taper layer 154. The deflectable portion of the membrane structure 130 may be defined by a (central) region an inner edge 156 of the second structured oxide layer 152 or by an edge, at which the inner surface of the second structured oxide layer 152 meets the structured taper layer 154.

A lateral extension of the cavity 122 may be larger than the lateral extension of the deflectable portion of the membrane structure 130 by less than 50 µm (e.g., in a range of 1 to 50 µm). For example, in the case of a rectangular membrane structure 130 (e.g., bridge-design), the lateral extension of the cavity 122 may be larger than the lateral extension of the deflectable portion of the membrane structure 130 by less than 50 µm. In the example of a circular membrane structure 130, the lateral extension of the cavity 122 may be larger than the lateral extension of the deflectable portion of the membrane structure 130 by less than 50 µm, if measured as a diameter, or less than 25µm if measured as a radius. In other words, the lateral extension of the cavity may be (e.g., between 1 and 25 µm) larger than the lateral extension (e.g., surface area) of the deflectable portion of the membrane structure 130.

The gap 148 may be formed between surfaces of the membrane structure 130 and support structure 120 facing each other, wherein the gap 148 may border the inner surface of the first clamping structure 140.

The second clamping structure 150 may be in direct contact with (e.g., attached to) at least one of the back-plate structure 110 and the membrane structure 130. Alternatively, one or more layers may be arranged between the second clamping structure 150 and at least one of the back-plate structure 110 and the membrane structure 130.

The second structured oxide layer 152 (e.g., oxide layer 1) may comprise or consist of an oxide of a semiconductor such as silicon (or a III-IV semiconductor). For example, the second structured oxide layer 152 may comprise or consist of silicon oxide, which may, for example be formed by a deposition using a precursor that comprises tetraethyl orthosilicate (TEOS). The second structured oxide layer 152 may have a thickness in a range of 0.1µm to 10.0 µm, e.g., in a range of 0.5 µm and 5.0 µm, e.g., 2.0 µm. The second structured oxide layer 152 may have a thickness that is larger (e.g., 1.5 to 10 times larger, e.g., twice as large) as a thickness of the first structured oxide layer 142.

The inner edge 156 of the second structured oxide layer 152 laterally (e.g., in x-direction) overlaps the cavity 122 (e.g., wherein a lateral distance between the inner edge 156 of the second structured oxide layer 152 and the central axis 132 may be shorter than a lateral distance between the edge 124 of the cavity 122 and the central axis 132). The inner edge 156 of the second structured oxide layer 152 may be laterally offset by an offset 151 relative to the edge 124 of the support structure. The lateral offset 151 may be constant (e.g., within a tolerance of ±5% or ±1%) along a perimeter of the support structure 120 (e.g., along the y-direction in case of a square shaped membrane structure 130, e.g., along an angular direction in case of a circular shaped membrane structure 130). The lateral offset or overlap 151 of the second structured oxide layer 152 over the edge 124 of the cavity 122 may be less than 50 µm, e.g., in a range between 1µm and 50 µm, e.g., between 1µm and 25 µm. It has been recognized that limiting the lateral offset 151 of the second structured oxide layer 152 over the edge 124 of the cavity 122 (e.g., to not exceed 20 µm) can improve the mechanical stability of the MEMS structure 100.

The structured taper layer 154 may be in direct contact with (e.g., attached to) at least one of the second structured oxide layer 152 and the membrane structure 130. Alternatively, one or more layers may be arranged between the structured taper layer 154 and at least one of the second structured oxide layer 152 and the membrane structure 130.

The structured taper layer 154 (e.g., taper layer) may comprise or consist of a compound comprising at least one of silicon and nitride, for example silicon monoxide nitride (SiON). SiON may have a higher wet etch affinity (e.g., compared to silicon oxide), which may provide a steep taper angle which can help in robustness topics. The structured taper layer 154 may be formed from a different material than the membrane structure 130 (e.g., not formed integrally with the membrane structure 130). The structured taper layer 154 and the tapered edge region 158 may be formed from the same material (e.g., formed integrally or in one piece). The tapered edge region 158 may be formed based on an etching process that etched the structured taper layer 154. The structured taper layer 154 may (e.g., in a non-tapered region, e.g., in a region separate from the tapered edge region 158) have a thickness in a range of 0.03 µm to 1.0 µm, e.g., in a range of 0.05 µm and 0.5 µm, e.g., 0.15 µm.

A non-tapered region of the structured taper layer 154 may extend laterally inward or outward beyond the inner edge 156 (e.g., in fig. 1 to the left or right of the inner edge 156) of the second structured oxide layer 152 on the membrane structure 130. A non-tapered region of the structured taper layer 154 may extend laterally inward or outward beyond a portion of an inner surface of the second structured oxide layer 152 that is closest or in contact with the structured taper layer 154.

Fig. 4 shows a schematic cross-section of an example of the tapered edge region 158. The tapered edge region 158 shown in fig. 4 may be a tapered edge region 158 of any MEMS structure 100 disclosed herein. The tapered edge region 158 may be combined with any MEMS structure 100 disclosed herein.

The cross-section of the tapered edge region 158 may be described by a triangle (e.g., a right triangle), wherein one leg (e.g., in fig. 4 the left leg), called taper height H, adjoins the non-tapered region of the structured taper layer 154 and a second leg (e.g., in fig. 4 at the bottom), called taper length L, adjoins (e.g., is attached to) the membrane structure 130. A third leg (e.g., a hypotenuse) of the triangle forms a surface of the tapering of the tapered edge region 158.

A taper angle α may be defined as an arcus tangents of a ratio of the taper height H and the taper length L: $α = arctan \left(\frac{H}{L}\right)$

The tapered edge region 158 of the structured taper layer 154 may have a tapering angle in a range of 1° and 45°, for example between 1° and 10°, e.g., between 1° and 5°. Alternatively, the tapered edge region 158 may have a tapering angle between 45° an 89°. A tapering angle of 45° or below has been found to improve a compromise between deflectability and stability.

The taper height H may be identical to a thickness of the structured taper layer 154. For example, the taper height H and the thickness of the structured taper layer 154 may be 0.15µm and the taper length L may be 1µm. In such a case, the taper angle α may be determined as α = arctan(0.15/1) ≈ 8.53°. In a different example, the taper height H may be 140 nm and the taper length L may be 2.8 µm. In such a case, the taper angle α may be determined as α = arctan(0.14/2.8) ≈ 2.86°. However, any other value may be selected for the taper length (e.g., depending on the taper height and/or taper angle). For example, the taper length may be in a range of 0.1µm and 20µm, e.g., 0.5µm and 10µm.

In the example shown in Fig. 4, the cross-section has a straight line (e.g., hypotenuse) describing a tapering surface. However, the tapering surface may be curved, e.g., concave or convex surface. A convex surface may improve stability and a concave surface may improve deflectability.

The tapered edge region 158 may taper from a thickness of the structured taper layer 154 to a thickness of zero. In other words, the tapered edge region 158 may have a tapering surface that meets (or transitions into) a surface of the membrane structure 130.

The tapered edge region 158 extend along an entire periphery of the membrane structure 130 or one or more portions thereof. For example, the tapered edge region 158 may extend along a clamped portion of the membrane structure 130. For example, the tapered edge region 158 may span the first and/or second clamping structure 140, 150 (or a portion or fraction thereof).

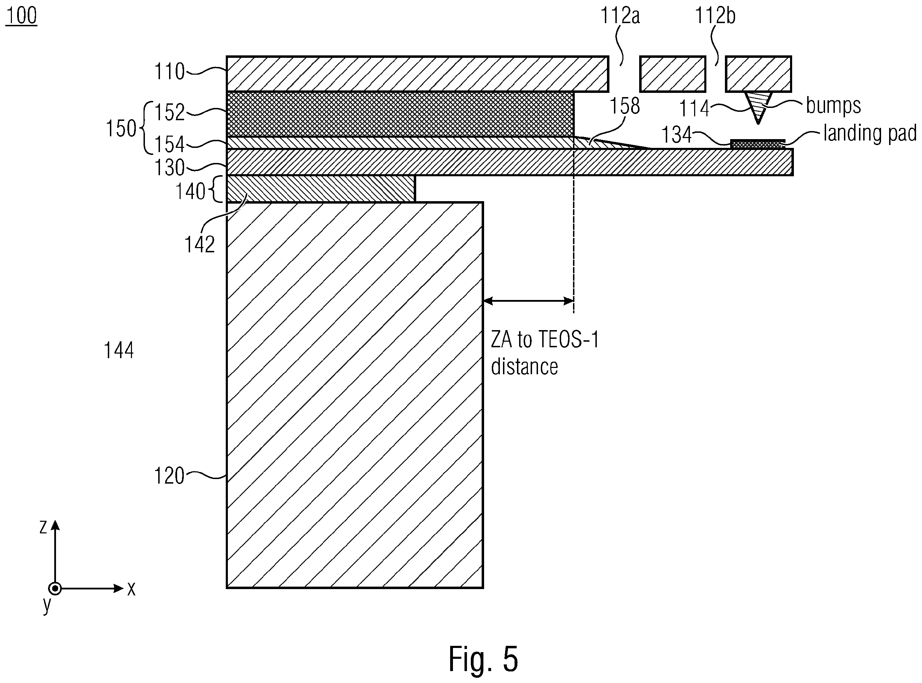

Fig. 5 shows a schematic cross-section of another example of a MEMS structure 100. The MEMS structure 100 shown in fig. 5 may be or comprise features of any MEMS structure 100 disclosed herein. The MEMS structure depicted in fig. 5 may comprise some or all features of any MEMS structure 100 disclosed herein.

The backplate-structure 110 of the MEMS structure 100 may comprise one or more apertures 112a, b. The one or more apertures 112a, b may have a circular, oval or rectangular shape. The one or more apertures 112a, b may have identical or different sizes. The one or more apertures 112a, b may have an homogenous or inhomogeneous distribution (e.g., within an aperture region of the membrane structure 130). For example, the backplate-structure 110 may comprise one or more aperture regions, in each of which a plurality of apertures 112a, b (e.g., with a circular shape) are arranged in a regular hexagonal pattern.

The MEMS structure 100 may comprise a back-plate structure 100 with one or more protrusions (or bumps or projections) 114 extending towards (e.g., parallel to the z-direction, e.g., in negative z-direction) the membrane structure 130. The one or more protrusions 114 may have a pyramidal or conical shape. The one or more protrusions 114 may function as spacers that reduce the risk of a physical contact between the back-plate structure 110 (e.g., other than the one or more protrusions 114) and the membrane structure 130.

Optionally, the membrane structure 130 may comprise one or more landing pads 134. For example, for one or more protrusions 114 may be provided one or more landing pads 134 (e.g., for each protrusion 114 may be provided one landing pad 134). The landing pads 134 may function as contact surface for protrusions 114 for reducing the risk of a direct contact of the protrusion 114 with a portion of the membrane structure 130 different than a landing pad 134. To this end, the landing pads 134 may comprise or be formed of a material that is harder than a material that forms a rest of the membrane structure 130 (e.g., a material of the membrane portion that forms a deflectable body of the membrane structure 130).

The membrane structure 130 may comprise landing pads 134 only at a region with the largest deflectability (e.g., a central region of the membrane structure 130 or membrane portion around or intersected by the central axis 132) or only at a region with the least deflectability (e.g., a peripheral region of the membrane structure 130 or membrane portion spaced apart or not intersected by the central axis 132). For example, the membrane structure 130 may comprise a region with corrugations, wherein the membrane structure 130 comprises one or more landing pads 134 outside the region with corrugations and may comprise no landing pads 134 (or a smaller density of landing pads 134) within the regions of corrugations. Alternatively or additionally, the back-plate structure 110 may comprise no protrusions 114 at a region of the back-plate structure 110 that corresponds to (e.g., is congruent to or may be contacted in case of deflection by) a region of the membrane structure 130 that comprises corrugations. The number of protrusions 114 and/or landing pads 134 may be reduced (or eliminated entirely) due to the improved stability of the MEMS structure 100.

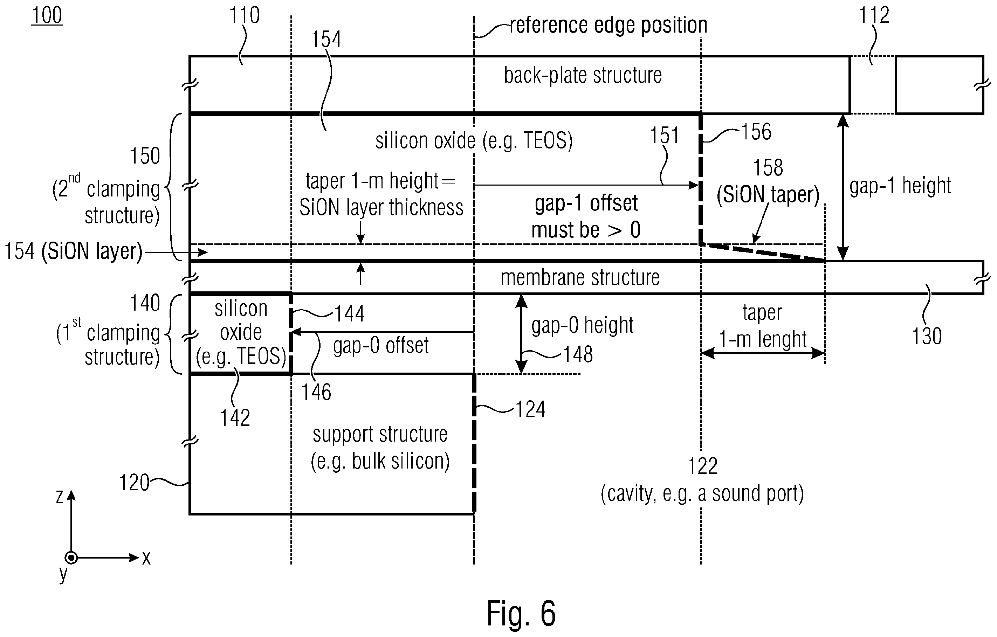

Fig. 6 shows a schematic cross-section of another example of a MEMS structure 100. The MEMS structure 100 shown in fig. 6 may be or comprise features of any MEMS structure 100 disclosed herein. Any features disclosed with reference to fig. 6 may be combined with or used in any other MEMS structure 100 disclosed herein.

The MEMS structure 100 comprises a cavity 122, wherein an edge 124 of the cavity 122 (e.g., a horizontal inner surface and/or an upper inner edge of the horizontal inner surface) may form a reference edge position.

An inner edge 144 of the first clamping structure 140 is laterally offset from the edge 146 of the cavity 122. For example, the inner edge 144 of the first clamping structure 140 may be spatially separated in a lateral direction by an offset 146 from the reference edge position. The offset 146 may, for example, extend parallel to the x-direction (e.g., in negative x-direction) or extend radially outwards (e.g., from the central axis 132).

An inner edge 156 of the second structured oxide layer 152 laterally extends over the cavity 122. For example, the inner edge 156 of the second structured oxide layer 152 may be spatially separated in a lateral direction by an offset 151 from the reference edge position. The offset 151 may, for example, extend parallel to the x-direction (e.g., in negative x-direction) or extend radially outwards (e.g., from the central axis 132).

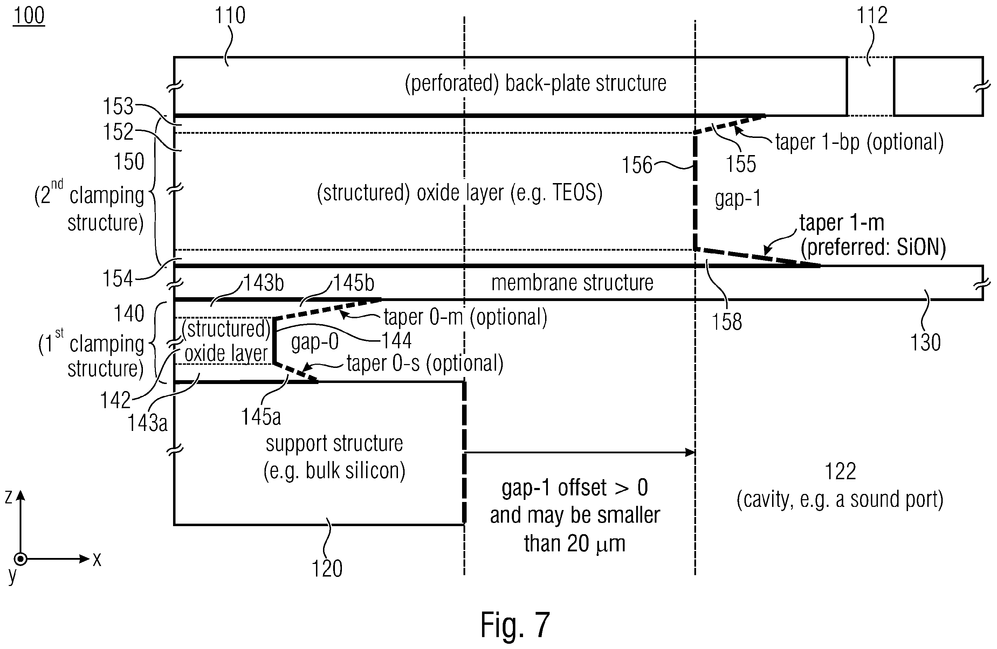

Fig. 7 shows a schematic cross section of another example of a MEMS structure 100. The MEMS structure 100 shown in fig. 7 may be or comprise features of any MEMS structure 100 disclosed herein. Any features disclosed with reference to fig. 7 may be combined with or used in any other MEMS structure 100 disclosed herein.

The first clamping structure 140 may further comprise a second structured taper layer 143a (e.g., taper 0-m) having a tapered edge region 145a (e.g., taper 0-s) between the first structured oxide layer 142 and the support structure 120. Alternatively or additionally, the first clamping structure 140 may further comprise a third structured taper layer 143b (e.g., taper 0-s) having a tapered edge region 145b (e.g., taper 0-m) between the first structured oxide layer 142 and the membrane structure 130. The second structured taper layer 143a may (or may not) be in direct contact with (e.g., attached to) at least one of the first structured oxide layer 142 and the support structure 120. The third structured taper layer 143b may (or may not) be in direct contact with (e.g., attached to) at least one of the first structured oxide layer 142 and the membrane structure 130.

The tapered edge region 145a of the second structured taper layer 143a may start at or laterally after (e.g., in a laterally inward direction, e.g., parallel to the x-direction) the edge 144 of the first structured oxide layer 142 (or a portion of the inner surface of the first structure oxide layer 142 that is arranged adjacent or meets the second structured taper layer 143a). The tapered edge region 145b of the third structured taper layer 143b starts at or laterally after (e.g., in a laterally inward direction, e.g., parallel to the x-direction) the edge 144 of the first structured oxide layer 142 (or a portion of the inner surface of the first structure oxide layer 142 that is arranged adjacent or meets the third structured taper layer 143b).

A taper length of the tapered edge region 145b of the third structured taper layer 143b may be larger (e.g., in a lateral and/or radial direction, e.g., parallel to the x-direction) than a taper length of the tapered edge region 145a of the second structured taper layer 143a. As a result, the membrane structure 130 (which may be under more mechanical stress than the back-plate structure 110) may have improved stability. Alternatively, the taper length of the tapered edge region 145b of the third structured taper layer 143b may be shorter than or equal to the taper length of the tapered edge region 145a of the second structured taper layer 143a.

The second clamping structure 150 may further comprise a fourth structured taper layer 153 having a tapered edge region 155 (e.g., taper 1-bp) between the back-plate structure 110 and the second structured oxide layer 152. The tapered edge region 155 of the fourth structured taper layer 153 may start at or laterally after (e.g., in a laterally inward direction, e.g., parallel to the x-direction) the edge 156 of the second structured oxide layer 152 (or a portion of the inner surface of the second structure oxide layer 152 that is arranged adjacent or meets the fourth structured taper layer 153).

A taper length of the tapered edge region 158 of the structured taper layer 154 may be larger (e.g., in a lateral and/or radial direction, e.g., parallel to the x-direction) than a taper length of the tapered edge region 155 of the fourth structured taper layer 153. As a result, the membrane structure 130 may have improved stability. Alternatively, taper length of the tapered edge region 158 of the structured taper layer 154 may be shorter than or equal to the taper length of the tapered edge region 155 of the fourth structured taper layer 153.

The taper length of the tapered edge region 158 of the structured taper layer 154 may be larger (e.g., in a lateral and/or radial direction, e.g., parallel to the x-direction) than a taper length of the taper length of the tapered edge region 145b of the third structured taper layer 143b. In other words, a taper length of tapered edge regions at the membrane structure 130 may be larger on a side of the membrane structure 130 that is facing the back-plate structure 110 (than on a side of the membrane structure 130 that is facing the support structure 120). Alternatively, the taper length may be equal or shorter on the side of the membrane structure 130 that is facing the back-plate structure 110.

The taper length of the tapered edge region 155 of the fourth structured taper layer 153 may be larger than the taper length of the tapered edge region 145a of the second structured taper layer 143a. Alternatively, the taper length of the tapered edge region 155 of the fourth structured taper layer 153 may be equal to or smaller than the taper length of the tapered edge region 145a of the second structured taper layer 143a.

Any specification of the structured taper layer 154 and/or the tapered edge region 158 disclosed herein (e.g., with reference to fig. 3 and 4) may be applicable to one or more of the second, third and fourth structured taper layer 143a, b, 153 and/or the tapered edge regions 145a, 145b, 155. For example, one or more of the second, third and fourth structured taper layer 143a, b, 153 may comprise a material and/or thickness as described with reference to fig. 3. Furthermore, one or more of the tapered edge regions 145a, 145b, 155 may have a tapering as described with reference to fig. 4.

Fig. 7 shows a MEMS structure 100 with all of the second, third and fourth structured taper layer 143a, b, 153. However, the MEMS structure 100 may comprise any other combination thereof, e.g., with none, or only one or two of the second, third and fourth structured taper layer 143a, b, 153. For example, the MEMS structure may comprise the structured taper layer 154 and the third structured taper layer 143b, but not the second structured taper layer 143a and the fourth structured taper layer 155 (or any other combination).

Fig. 8 shows a schematic cross section of another example of a MEMS structure 100. The MEMS structure 100 shown in fig. 8 may be or comprise features of any MEMS structure 100 disclosed herein. Any features disclosed with reference to fig. 8 may be combined with or used in any other MEMS structure 100 disclosed herein.

The first clamping structure 140 may comprise an intermediate layer 147 (e.g., an etch-support layer, e.g., a layer comprising or formed by phosphosilicate glass, PSG) within the first structured oxide layer 142, and wherein an inner lateral surface (e.g., edge region) of the first structured oxide layer 142 tapers (e.g., double tapering towards a notch, e.g., double tapering towards the intermediate layer 147, e.g., an upper and lower tapering) towards the intermediate layer 147.

The second clamping structure 150 comprises an intermediate layer 157 (e.g., an etch-support layer, e.g., a layer comprising or formed by phosphosilicate glass, PSG) within the second structured oxide layer 152, and wherein an inner lateral surface of the second structured oxide layer tapers towards (e.g., double tapering towards a notch, e.g., double tapering towards the intermediate layer 157, e.g., an upper and lower tapering) the intermediate layer 157.

A first portion of the second structured oxide layer 152 between the intermediate layer 157 and the membrane structure 130 may be considered the structured taper layer 154, wherein a second portion of the second structured oxide layer 152 may be considered the second structured oxide layer 152 (e.g., in which case a combination of the intermediate layer 157 and the first and second portion of the second structured oxide layer 152 may form or be part of the second clamping structure 150). Alternatively, the second clamping structure 150 may comprise a further layer between the second structured oxide layer 152 shown in fig. 8 and the membrane structure 130 that forms or comprises any other structured taper layer 154 disclosed herein.

In the following, further optional details will be described for the first clamping structure 140 with the intermediate layer 147. However, the same features and principles may apply alternatively or in combination to the second clamping structure 150 with the intermediate layer 157.

The intermediate layer 147 may be arranged at any height within the first clamping structure 140. For example, the intermediate layer 147 may be arranged at an upper or lower end of the first structured oxide layer 142 (e.g., between the first structured oxide layer 142 and the base structure 120 or the membrane structure 130) or centrally within the first structured oxide layer 142 or centrally between base structure 120 and the membrane structure 130. The intermediate layer 147 may be arranged within the first structured oxide layer 142 and closer to base structure 120 than to the membrane structure 130 (e.g., in a bottom half) or close to the membrane structure 130 than the base structure 120 (e.g., in a top half).

The intermediate layer 147 may have a smaller thickness than a total of thickness of the first structured oxide layer 142 (including portions below and/or above the intermediate layer 147). For example, the intermediate layer 147 may have a thickness that is smaller than 50%, 25%, 10%, 1% or smaller than a total of thickness of the first structured oxide layer 142.

The intermediate layer 147 may comprise or form a fast-etching layer (e.g., PSG), which may be etched at a faster rate than the first structured oxide layer 142 (e.g., using a wet or dry etching process). Introduction of a structured fast-etching layer (e.g. PSG) into the first structured oxide layer 142 (e.g., gap oxide) may allow fabricating tapers (e.g., double tapering) by (or towards) a recess of the first structured oxide layer 142 (e.g., oxide, e.g., TEOS) during an etching process (e.g., during a release etch, e.g., when the gap-0 or gap-1 is formed, e.g., when the first or second structured oxide layer 142, 152 is formed).

For example, forming the first clamping structure 140 may comprise a first deposition of material of the first structured oxide layer 142, followed by a second deposition of material of the intermediate layer 147, followed by a third deposition of material of the first structured oxide layer 142, e.g., forming a sandwich structure. Forming the first clamping structure 140 may further comprise structuring a mask for etching (e.g., a mask that prevents etching at an outer periphery but allows etching an inner region of the first clamping structure 140). Forming the first clamping structure 140 may comprise performing an etching step that etches the intermediate layer 147 at a faster rate than the first structured oxide layer 142. As a result, an inner lateral surface of the intermediate layer 147 may recess faster than first structured oxide layer 142 which may result in the inner surface of the first clamping structure 140 forming a recess or notch that is laterally arranged further outside at the intermediate layer 147 than at the first structured oxide layer 142. The etching process may further expose more surface of the first structured oxide layer 142 at the intermediate layer 147 (compared to regions that are further away from the intermediate layer 147), which allows the etching process to remove more material of the first structured oxide layer 142 closer to the intermediate layer 147. As a result, first structured oxide layer 142 may be etched more (or recessed more or tapered more) with a decreasing distance to the intermediate layer 147. Therefore, the surface of the first structured oxide layer 142 may comprise one or more taper towards the intermediate layer 147.

The first structured oxide layer 142 of the first clamping structure 140 may comprise a first inner lateral surface with a first tapered shape and a second inner lateral surface (e.g., spatially separated in a vertical direction) with a second tapered shape (e.g., different from the first tapered shape).

The tapering of the first structured oxide layer 142 towards the intermediate layer 147 may form a "subtractive" taper, e.g., of a "PSG type" by means of one or more "PSG" taper layers in between the first and or second structured oxide layer 142, 152.

In the example shown in fig. 8, the intermediate layer 147 of the first clamping structure 140 is arranged centrally within the first structured oxide layer 142 and the intermediate layer 157 of the second clamping structure 150 is arranged closer to the membrane structure 130 than to the back-plate structure 110 (e.g., upper half of the second structured oxide layer 152). However, any of the intermediate layers 147, 157 may be arranged at any height in any combination. Furthermore, only one (or none) of the first and second clamping structures 140, 150 may comprise an intermediate layer 147, 157 (e.g., only the first clamping structure 140 or only the second clamping structure 150).

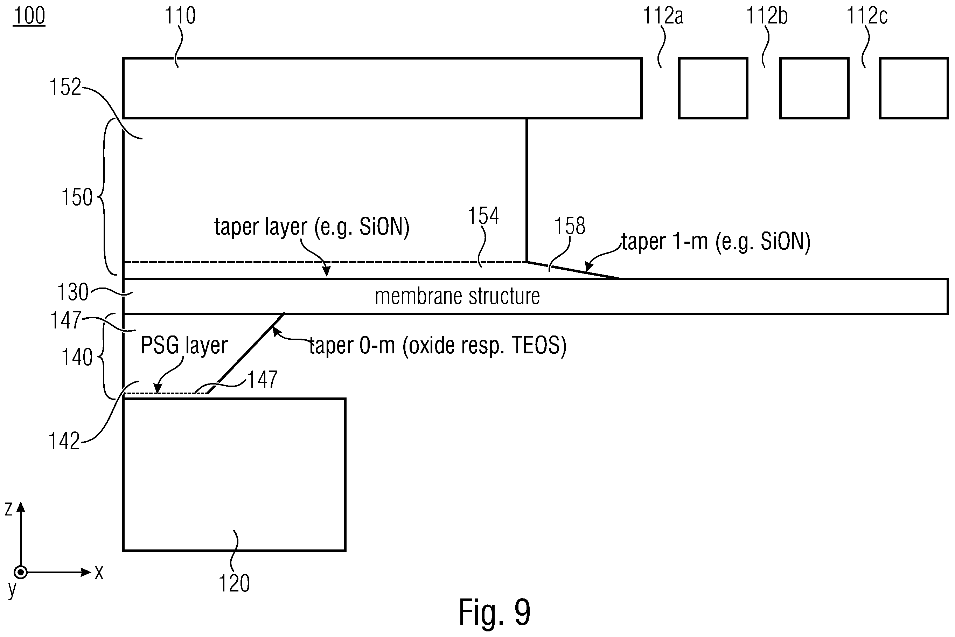

Fig. 9 shows a schematic cross section of another example of a MEMS structure 100. The MEMS structure 100 shown in fig. 9 may be or comprise features of any MEMS structure 100 disclosed herein. Any features disclosed with reference to fig. 9 may be combined with or used in any other MEMS structure 100 disclosed herein.

The first clamping structure 140 may comprise an intermediate layer 147 (e.g., an etch-support layer, e.g., a layer comprising or formed by phosphosilicate glass, PSG) between the first structured oxide layer 142 and the support structure 120 (wherein the intermediate layer 147 is indicated in fig. 9 as a dashed line), and wherein an inner lateral surface (edge region) of the first structured oxide layer 142 tapers towards the intermediate layer 147.

Since the intermediate layer 147 is arranged at one end of the first structured oxide layer 142 tapers (e.g., in fig. 9 at an end facing the base structure 120), the inner lateral surface of the first structured oxide layer 142 may only have one tapering surface (e.g., in a region above the intermediate layer 147). In comparison to the example shown in fig. 8, the inner lateral surface of the first structured oxide layer 142 has a tapering surface above and below the intermediate layer 147.

The MEMS structure 100 shown in fig. 9 has an intermediate layer 147 at a lower end of the first structured oxide layer 142 (e.g., between the first structured oxide layer 142 and the base structure 120). Alternatively, the intermediate layer 147 may be arranged at an upper end of the first structured oxide layer 142 (e.g., between the first structured oxide layer 142 and the membrane structure 130). Additionally or alternatively, the second clamping structure 150 may have an intermediate layer 157 within the second structured oxide layer 152 (e.g., as discussed with reference to fig. 8) or at a top of bottom of the second structured oxide layer 152 (e.g., between the second structured oxide layer 152 and the structured taper layer 154 or the back-plate structure 110.

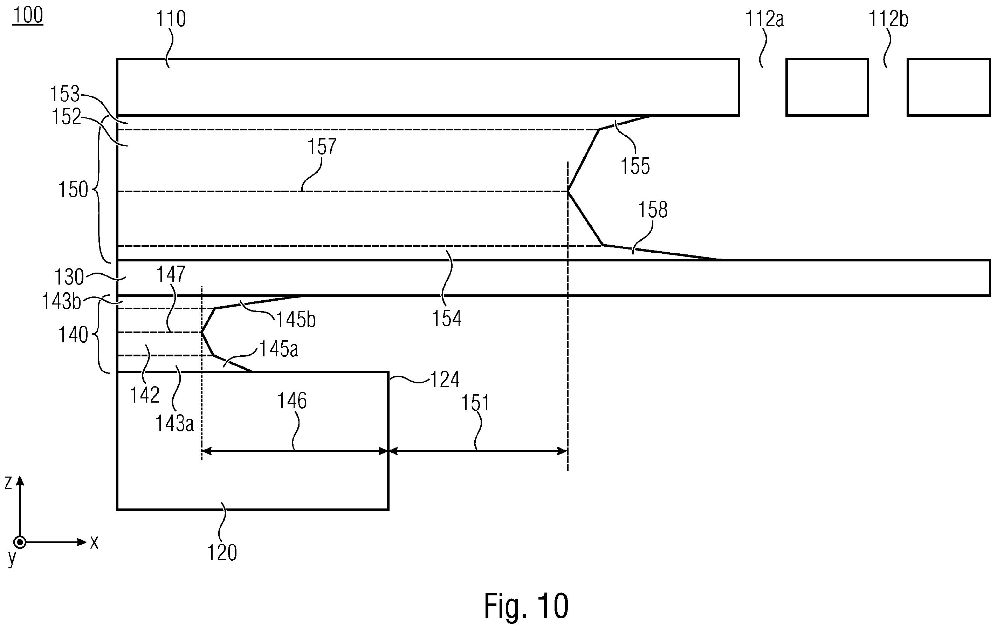

Fig. 10 shows a schematic cross section of another example of a MEMS structure 100. The MEMS structure 100 shown in fig. 10 may be or comprise features of any MEMS structure 100 disclosed herein. Any features disclosed with reference to fig. 10 may be combined with or used in any other MEMS structure 100 disclosed herein.

Fig. 10 essentially depicts a combination of subtractive tapering and additive tapering. The first structured oxide layer 142 comprises an intermediate layer 147 with an inner lateral surface tapering towards the intermediate layer 147 and the second structured oxide layer 152 comprises an intermediate layer 157 with an inner lateral surface tapering towards the intermediate layer 157 in any form as described herein.

Furthermore, the first clamping structure 140 comprises a second structured taper layer 143a between the first structured oxide layer 142 and the base structure 120 and a third second structured taper layer 143b between the first structured oxide layer 142 and the membrane structure 120. The first and second structured taper layer 143a, b may be realized in any form as described herein.

The second clamping structure 150 comprises a structured taper layer 154 between the second structured oxide layer 152 and the membrane structure 130 and may be realized in any way as described herein. Furthermore, the second clamping structure 150 comprises a fourth structured taper layer 153 between the second structured oxide layer 152 and the back-plate structure 110 and may be realized in any way described herein.

The tapering angle of the tapered edge region 158 may be smaller than a tapering angle for the inner lateral surface of the second structured oxide layer 152 adjacent to the structured taper layer 154. In other words, when the lateral inner surface of the second clamping structure 150 transitions from the tapered edge region 158 to the second structured oxide layer 152, an angle between a vertical direction (e.g., perpendicular to the membrane structure 130, e.g., parallel to the z-direction) and a surface normal of the lateral inner surface of the second clamping device 150 may increase. In other words, a steepness of the lateral inner surface of the second clamping device 150 may increase from the tapered edge region 158 to the second structured oxide layer 152.

Similarly, the steepness of the inner lateral surface may increase for one or more of the second, third, and fourth tapered edge regions 145a, 145b, 155 when transitioning towards the first or second structured oxide layer 142, 152, respectively.

Alternatively, for at least one of the tapered edge region 158, and the second, third, and fourth tapered edge regions 145a, 145b, 155, the steepness of the inner lateral surface may decrease when transitioning towards the first or second structured oxide layer 142, 152, respectively.

It is noted that the tapering towards the intermediate layers 147, 157 is depicted with straight lines in fig. 8 to 10. However, the tapering of the inner lateral surfaces may have a curved shape, such as a convex or concave shape. For example, in the case of an intermediate layer within a structured oxide layer 142, 152, e.g., within the first structured oxide layer 142 shown in fig. 8, the inner lateral surface of the first structured oxide layer 142 may have a convex (or concave) shape above and below the intermediate layer 147, wherein the two convex surfaces meet at a recess located at the intermediate layer 147. In a different example, in the case of an intermediate layer 147 at a bottom or top of a structured oxide layer 142, 152, e.g., between the base substrate 120 and the first structured oxide layer 142 as shown in fig. 9, the inner lateral surface of the first structured oxide layer 142 may comprise only one convex (or concave) tapering extending to the bottom of the first structured oxide layer 142.

It is further noted that fig. 10 shows a combination of the second, third, and fourth tapered edge regions 145a, 145b, 155 (e.g., additive tapering) and the first and second structured oxide layer 142, 152 tapering towards respective intermediate layers 147, 157 (e.g., subtractive tapering). However, the MEMS structure 100 may comprise any combination of one or more of the second, third, and fourth tapered edge regions 145a, 145b, 155 (e.g., none, one, two, or all three) with one or more of the first and second structured oxide layer 142, 152 tapering towards respective intermediate layers 147, 157 (e.g., the first and second structured oxide layer 142, 152 having no intermediate layers, or only one have of them having an intermediate layer 147, 157, or both of them having an intermediate layer 147, 157).

The tapering of the tapered edge region 158 may result in an increase of an overall thickness of a combination of the membrane structure 130 and the structured taper layer 154 along a lateral outside direction. As a result, stress and forces at a transition between a deflectable portion and a non-deflectable portion of the membrane structure 130 can be distributed more evenly, which can reduce the risk of mechanical failure. Peaks in stress and forces may also occur between the first clamping structure 140 and the support structure 120 and/or the membrane structure 130 as well as between the second clamping structure 150 and the back-plate structure 110. The first, second, and third structured taper layer 143a, b, 153 may similarly reduce peak forces and stress at these locations, which can subsequently reduce the risk or mechanical failure.

The tapering of the first and/or second structured oxide layer 142, 152 can also provide a change in thickness that can alleviate stress as discussed above. A combination of the tapering of the first and/or second structured oxide layer 142, 152 with one or more of tapered edge regions 145a, 145b, 155, 158 may form an overall larger transition of material thickness, which can further enhance the mechanical stability. This may further be amplified by an increase of steepness towards the first and/or second structured oxide layer 142, 152, which can result in an overall increase of material thickness that provides good stability as well as deflectabability of the membrane structure 130.

Further may be provided a MEMS device comprising the MEMS structure 100, wherein the MEMS device is configured to generate an electrical signal depending on and/or controlling a deflection of the membrane structure 130. For the example, the MEMS device may be or may comprise a microphone with the membrane structure 130 as transducer (e.g., configured to generate an electrical signal based on a deflection of the membrane structure 130, e.g., converting incoming sound to an electrical signal). The MEMS device may be or may comprise an audio speaker (or loudspeaker) with the membrane structure 130 as transducer (e.g., configured to control a deflection of the membrane structure 130, e.g., configured to convert an electrical signal for deflecting the membrane structure 130 in order to generate sound).

Additional embodiments and aspects are described which may be used alone or in combination with the features and functionalities described herein.

According to an embodiment, a MEMS structure comprises a back-plate structure, a support structure having a cavity, a membrane structure between the back-plate structure and the support structure; a first clamping structure having a first structured oxide layer between the support structure and the membrane structure, wherein an inner edge of the first clamping structure is laterally offset from an edge of the cavity, wherein the offset of the first clamping structure forms a gap between the support structure and the membrane structure, and a second clamping structure having a second structured oxide layer and a structured taper layer between the back-plate structure and the membrane structure, wherein the second structured oxide layer is arranged between the back-plate structure and the structured taper layer, and wherein an inner edge of the second structured oxide layer laterally extends over the cavity, and wherein the structured taper layer is arranged between the second structured oxide layer and the membrane structure and has a tapered edge region, which laterally extends be-yond the edge of the second structured oxide layer on the membrane structure.

According to an embodiment, a lateral offset (of an inner edge) of the first structured oxide layer to the edge of the cavity is less than 15 µm (or 10 µm) or is between 1 and 15 µm.

According to an embodiment, a lateral offset (or overlap) of the second structured oxide layer over the edge of the cavity is less than 25 µm (or 20 µm) or is between 1 and 25 µm.

According to an embodiment, the tapered edge region of the structured taper layer starts at or laterally after the edge of the second structured oxide layer.

According to an embodiment, the tapered edge region of the structured taper layer has a tapering angle between 1° and 45°.

According to an embodiment, the first clamping structure further comprises at least one of a second structured taper layer having a tapered edge region between the first structured oxide layer and the support structure and a third structured taper layer having a tapered edge region between first structured oxide layer and the membrane structure.

According to an embodiment, the tapered edge region of the second structured taper layer starts at or laterally after the edge of the first structured oxide layer.

According to an embodiment, the tapered edge region of the third structured taper layer starts at or laterally after the edge of the first structured oxide layer.

According to an embodiment, the first clamping structure comprises an intermediate layer (e.g., etch-support layer - PSG layer) between the first structured oxide layer and the support structure, and wherein an inner lateral surface (e.g., edge region) of the first structured oxide layer tapers towards the intermediate layer.

According to an embodiment, the first clamping structure comprises an intermediate layer (e.g., etch-support layer - PSG layer) within the first structured oxide layer, and wherein an inner lateral surface (e.g., edge region) of the first structured oxide layer tapers (e.g., double tapering towards a notch) towards the intermediate layer.

According to an embodiment, the second clamping structure comprises an intermediate layer (e.g., etch-support layer - PSG layer) within the second structured oxide layer, and wherein an inner lateral surface of the second structured oxide layer tapers towards the intermediate layer.

According to an embodiment, the second clamping structure further comprises a fourth structured taper layer having a tapered edge region between the back-plate structure and the second structured oxide layer.

According to an embodiment, the tapered edge region of the fourth structured taper layer starts at or laterally after the edge of the second structured oxide layer.

According to an embodiment, an exposed center region of the membrane structure (e.g., within the inner edge of the second structured oxide layer) forms a deflectable region of the membrane structure.

According to an embodiment, the MEMS structure is a sound transducer with a single back-plate.

According to an embodiment, the MEMS structure is a single back-plate microphone.

According to an embodiment, the membrane structure comprises in a border region (e.g., which is not covered by the tapered edge region of the structured taper layer), which comprises a corrugation which is directed to the support structure.

According to an embodiment, second structured oxide layer has a thickness in a range of 0.5 µm and 5.0 µm and the structured taper layer has a thickness in a range of 0.05 µm and 0.5 µm

Although some aspects have been described as features in the context of an apparatus it is clear that such a description may also be regarded as a description of corresponding features of a method. Although some aspects have been described as features in the context of a method, it is clear that such a description may also be regarded as a description of corresponding features concerning the functionality of an apparatus.

## Claims

1. MEMS structure (100), comprising:
a back-plate structure (110),
a support structure (120) having a cavity (122),
a membrane structure (130) between the back-plate structure (110) and the support structure (120),
a first clamping structure (140) having a first structured oxide layer (142) between the support structure (120) and the membrane structure (130),
wherein an inner edge (144) of the first clamping structure (140) is laterally offset (146) from an edge of the cavity (122), wherein the offset (146) of the first clamping structure (140) forms a gap (148) between the support structure (120) and the membrane structure (130), and
a second clamping structure (150) having a second structured oxide layer (152) and a structured taper layer (154) between the back-plate structure (110) and the membrane structure (130),
wherein the second structured oxide layer (152) is arranged between the back-plate structure (110) and the structured taper layer (154), and wherein an inner edge (156) of the second structured oxide layer (152) laterally extends over the cavity (122), and
wherein the structured taper layer (154) is arranged between the second structured oxide layer (152) and the membrane structure (130) and has a tapered edge region (158), which laterally extends beyond the edge (156) of the second structured oxide layer (152) on the membrane structure (130).

2. The MEMS structure (100) of claim 1, wherein a lateral offset (146) of the first structured oxide layer (142) to the edge of the cavity (122) is less than 15 µm or is between 1 and 15 µm.

3. The MEMS structure (100) of claim 1 or 2, wherein a lateral offset or overlap of the second structured oxide layer (152) over the edge of the cavity (122) is less than 25 µm or is between 1 and 25 µm.

4. The MEMS structure (100) of any of the preceding claims, wherein the tapered edge region (158) of the structured taper layer (154) starts at or laterally after the edge (156) of the second structured oxide layer (152).

5. The MEMS structure (100) of claim 4, wherein the tapered edge region (158) of the structured taper layer (154) has a tapering angle (α) between 1° and 45°.

6. The MEMS structure (100) of any of the preceding claims, wherein the first clamping structure (140) further comprises at least one of
a second structured taper layer (143a) having a tapered edge region (145a) between the first structured oxide layer (142) and the support structure (120) and
a third structured taper (143b) layer having a tapered edge region (145b) between first structured oxide layer (142) and the membrane structure (130).

7. The MEMS structure (100) of claim 6, wherein the tapered edge region (145a) of the second structured taper layer (143a) starts at or laterally after the edge (144) of the first structured oxide layer (142).

8. The MEMS structure (100) of claim 6 or 7, wherein the tapered edge region (145b) of the third structured taper layer (143a) starts at or laterally after the edge (144) of the first structured oxide layer (142).

9. The MEMS structure (100) of any of the preceding claims, wherein the first clamping structure (140) comprises an intermediate layer (147) between the first structured oxide layer (142) and the support structure (120), and wherein an inner lateral surface of the first structured oxide layer (142) tapers towards the intermediate layer (147).

10. The MEMS structure (100) of any of the preceding claims, wherein the first clamping structure (140) comprises an intermediate layer (147) within the first structured oxide layer (142), and wherein an inner lateral surface of the first structured oxide layer tapers (142) towards the intermediate layer (147).

11. The MEMS structure (100) of any of the preceding claims, wherein the second clamping structure (150) comprises an intermediate layer (157) within the second structured oxide layer (152), and wherein an inner lateral surface of the second structured oxide layer (152) tapers towards the intermediate layer (157).

12. The MEMS structure (100) of any of the preceding claims, wherein the second clamping structure (150) further comprises a fourth structured taper layer (153) having a tapered edge region (155) between the back-plate structure (110) and the second structured oxide layer (152).

13. The MEMS structure (100) of claim 12, wherein the tapered edge region (155) of the fourth structured taper layer (153) starts at or laterally after the edge (156) of the second structured oxide layer (152).

14. The MEMS structure (100) of any of the preceding claims, wherein an exposed center region of the membrane structure (130) forms a deflectable region of the membrane structure (130).

15. The MEMS structure (100) of any of the preceding claims, wherein the MEMS structure (100) is a sound transducer with a single back-plate (110).

16. The MEMS structure (100) of any of the preceding claims, wherein the MEMS structure is a single back-plate microphone.

17. The MEMS structure (100) according to any of the preceding claims, wherein the membrane structure (130) comprises a border region with a corrugation, which is directed to the support structure (120).

18. The MEMS structure (100) according to any of the preceding claims, wherein second structured oxide layer (152) has a thickness in a range of 0.5 µm and 5.0 µm and the structured taper layer (154) has a thickness in a range of 0.05 µm and 0.5 µm.

## Patentansprüche

1. MEMS-Struktur (100), die folgende Merkmale aufweist:
eine Rückplattenstruktur (110),
eine Stützstruktur (120), die einen Hohlraum (122) aufweist,
eine Membranstruktur (130) zwischen der Rückplattenstruktur (110) und der Stützstruktur (120),
eine erste Klemmstruktur (140), die eine erste strukturierte Oxidschicht (142) zwischen der Stützstruktur (120) und der Membranstruktur (130) aufweist,
wobei eine Innenkante (144) der ersten Klemmstruktur (140) von einer Kante des Hohlraums (122) seitlich versetzt (146) ist, wobei der Versatz (146) der ersten Klemmstruktur (140) einen Zwischenraum (148) zwischen der Stützstruktur (120) und der Membranstruktur (130) bildet, und
eine zweite Klemmstruktur (150), die eine zweite strukturierte Oxidschicht (152) und eine strukturierte Verjüngungsschicht (154) zwischen der Rückplattenstruktur (110) und der Membranstruktur (130) aufweist,
wobei die zweite strukturierte Oxidschicht (152) zwischen der Rückplattenstruktur (110) und der strukturierten Verjüngungsschicht (154) angeordnet ist, und wobei sich eine Innenkante (156) der zweiten strukturierten Oxidschicht (152) seitlich über den Hohlraum (122) erstreckt, und
wobei die strukturierte Verjüngungsschicht (154) zwischen der zweiten strukturierten Oxidschicht (152) und der Membranstruktur (130) angeordnet ist und einen verjüngten Kantenbereich (158) aufweist, der sich auf der Membranstruktur (130) seitlich über die Kante (156) der zweiten strukturierten Oxidschicht (152) hinaus erstreckt.

2. MEMS-Struktur (100) gemäß Anspruch 1, wobei ein seitlicher Versatz (146) der ersten strukturierten Oxidschicht (142) zu der Kante des Hohlraums (122) weniger als 15 µm beträgt oder zwischen 1 und 15 µm beträgt.

3. MEMS-Struktur (100) gemäß Anspruch 1 oder 2, wobei ein seitlicher Versatz oder eine seitliche Überlappung der zweiten strukturierten Oxidschicht (152) über die Kante des Hohlraums (122) weniger als 25 µm beträgt oder zwischen 1 und 25 µm beträgt.

4. MEMS-Struktur (100) gemäß einem der vorhergehenden Ansprüche, wobei der verjüngte Kantenbereich (158) der strukturierten Verjüngungsschicht (154) an oder seitlich nach der Kante (156) der zweiten strukturierten Oxidschicht (152) beginnt.

5. MEMS-Struktur (100) gemäß Anspruch 4, wobei der verjüngte Kantenbereich (158) der strukturierten Verjüngungsschicht (154) einen Verjüngungswinkel (α) zwischen 1° und 45° aufweist.

6. MEMS-Struktur (100) gemäß einem der vorhergehenden Ansprüche, wobei die erste Klemmstruktur (140) ferner zumindest eines der folgenden Merkmale aufweist:
eine zweite strukturierte Verjüngungsschicht (143a), die einen verjüngten Kantenbereich (145a) zwischen der ersten strukturierten Oxidschicht (142) und der Stützstruktur (120) aufweist, und
eine dritte strukturierte Verjüngungsschicht (143b), die einen verjüngten Kantenbereich (145b) zwischen der ersten strukturierten Oxidschicht (142) und der Membranstruktur (130) aufweist.

7. MEMS-Struktur (100) gemäß Anspruch 6, wobei der verjüngte Kantenbereich (145a) der zweiten strukturierten Verjüngungsschicht (143a) an oder seitlich nach der Kante (144) der ersten strukturierten Oxidschicht (142) beginnt.

8. MEMS-Struktur (100) gemäß Anspruch 6 oder 7, wobei der verjüngte Kantenbereich (145b) der dritten strukturierten Verjüngungsschicht (143a) an oder seitlich nach der Kante (144) der ersten strukturierten Oxidschicht (142) beginnt.

9. MEMS-Struktur (100) gemäß einem der vorhergehenden Ansprüche, wobei die erste Klemmstruktur (140) eine Zwischenschicht (147) zwischen der ersten strukturierten Oxidschicht (142) und der Stützstruktur (120) aufweist, und wobei sich eine Innenseitenoberfläche der ersten strukturierten Oxidschicht (142) in Richtung der Zwischenschicht (147) verjüngt.

10. MEMS-Struktur (100) gemäß einem der vorhergehenden Ansprüche, wobei die erste Klemmstruktur (140) eine Zwischenschicht (147) innerhalb der ersten strukturierten Oxidschicht (142) aufweist, und wobei sich eine Innenseitenoberfläche der ersten strukturierten Oxidschicht (142) in Richtung der Zwischenschicht (147) verjüngt.

11. MEMS-Struktur (100) gemäß einem der vorhergehenden Ansprüche, wobei die zweite Klemmstruktur (150) eine Zwischenschicht (157) innerhalb der zweiten strukturierten Oxidschicht (152) aufweist, und wobei sich eine Innenseitenoberfläche der zweiten strukturierten Oxidschicht (152) in Richtung der Zwischenschicht (157) verjüngt.

12. MEMS-Struktur (100) gemäß einem der vorhergehenden Ansprüche, wobei die zweite Klemmstruktur (150) ferner eine vierte strukturierte Verjüngungsschicht (153) aufweist, die einen verjüngten Kantenbereich (155) zwischen der Rückplattenstruktur (110) und der zweiten strukturierten Oxidschicht (152) aufweist.

13. MEMS-Struktur (100) gemäß Anspruch 12, wobei der verjüngte Kantenbereich (155) der vierten strukturierten Verjüngungsschicht (153) an oder seitlich nach der Kante (156) der zweiten strukturierten Oxidschicht (152) beginnt.

14. MEMS-Struktur (100) gemäß einem der vorhergehenden Ansprüche, wobei ein freiliegender Mittelbereich der Membranstruktur (130) einen ablenkbaren Bereich der Membranstruktur (130) bildet.

15. MEMS-Struktur (100) gemäß einem der vorhergehenden Ansprüche, wobei die MEMS-Struktur (100) ein Schallwandler mit einer einzigen Rückplatte (110) ist.

16. MEMS-Struktur (100) gemäß einem der vorhergehenden Ansprüche, wobei die MEMS-Struktur ein einziges Rückplattenmikrofon ist.

17. MEMS-Struktur (100) gemäß einem der vorhergehenden Ansprüche, wobei die Membranstruktur (130) einen Grenzbereich mit einer Wellung aufweist, die zu der Stützstruktur (120) gerichtet ist.

18. MEMS-Struktur (100) gemäß einem der vorhergehenden Ansprüche, wobei die zweite strukturierte Oxidschicht (152) eine Dicke in einem Bereich von 0,5 µm und 5,0 µm aufweist und die strukturierte Verjüngungsschicht (154) eine Dicke in einem Bereich von 0,05 µm und 0,5 µm aufweist.

## Revendications

1. Structure (100) MEMS, comprenant :
une structure (110) de plaque arrière,
une structure (120) de support ayant une cavité (122),
une structure (130) de membrane entre la structure (110) de plaque arrière et la structure (120) de support,
une première structure (140) de fixation de niveau ayant une première couche (142) structurée d'oxyde entre la structure (120) de support et la structure (130) de membrane,
dans laquelle un bord (144) intérieur de la première structure (140) de fixation de niveau est décalé (146) latéralement d'un bord de la cavité (122), dans laquelle le décalage (146) de la première structure (140) de fixation de niveau forme un intervalle (148) entre la structure (120) de support et la structure (130) de membrane, et
une deuxième structure (150) de fixation de niveau ayant une première couche (152) structurée d'oxyde et une couche (154) conique structurée entre la structure (110) de plaque arrière et la structure (130) de membrane,
dans laquelle la couche (152) structurée d'oxyde est disposée entre la structure (110) de plaque arrière et la structure (154) conique structurée, et dans laquelle un bord (156) arrière de la deuxième couche (152) structurée d'oxyde s'étend latéralement sur la cavité (122), et
dans laquelle la couche (154) conique structurée est disposée entre la deuxième couche (152) structurée d'oxyde et la structure (130) de membrane et a une région (158) conique de bord, qui s'étend latéralement au-delà du bord (156) de la deuxième couche (152) structurée d'oxyde sur la structure (130) de membrane.

2. La structure (100) MEMS selon la revendication 1, dans laquelle un décalage (146) latéral de la première couche (142) structurée d'oxyde par rapport au bord de la cavité (122) est plus petit que 15 µm ou est compris entre 1 et 15 µm.

3. La structure (100) MEMS selon la revendication 1 ou 2, dans laquelle un décalage latéral ou un chevauchement de la deuxième couche (152) structurée d'oxyde par rapport au bord de la cavité (122) est plus petit que 25 µm ou est compris entre 1 et 25 µm.

4. La structure (100) MEMS selon l'une quelconque des revendications précédentes, dans laquelle la région (158) conique de bord de la couche (154) conique structurée commence à ou latéralement après le bord (156) de la deuxième couche (152) structurée d'oxyde.

5. La structure (100) MEMS selon la revendication 4, dans laquelle la région (158) conique de bord de la couche (154) conique structurée a un angle (α) de conicité compris entre 1° et 45°.

6. La structure (100) MEMS selon l'une quelconque des revendications précédentes, dans laquelle la première structure (140) de fixation de niveau comprend en outre au moins l'une de
une deuxième couche (143a) conique structurée ayant une région (145a) conique de bord entre la première couche (142) structurée d'oxyde et la structure (120) de support, et
une troisième couche (143b) conique structurée ayant une région (145b) conique de bord entre la première couche (142) structurée d'oxyde et la structure (130) de membrane.

7. La structure (100) MEMS selon la revendication 6, dans laquelle la région (145a) conique de bord de la deuxième couche (143a) conique structurée commence à ou latéralement après le bord (144) de la première couche (142) structurée d'oxyde.

8. La structure (100) MEMS selon la revendication 6 ou 7, dans laquelle la région (145b) conique de bord de la troisième couche (143a) conique structurée commence à ou latéralement après le bord (144) de la première couche (142) structurée d'oxyde.

9. La structure (100) MEMS selon l'une quelconque des revendications précédentes, dans laquelle la première structure (140) de fixation de niveau comprend une couche (147) intermédiaire entre la première couche (142) structurée d'oxyde et la structure (120) de support, et dans laquelle une surface latérale intérieure de la première couche (142) structurée d'oxyde est conique en direction de la couche (147) intermédiaire.

10. La structure (100) MEMS selon l'une quelconque des revendications précédentes, dans laquelle la première structure (140) de fixation de niveau comprend une couche (147) intermédiaire au sein de la première couche (142) structurée d'oxyde, et dans laquelle une surface latérale intérieure de la première couche structurée d'oxyde est conique (142) en direction de la couche (147) intermédiaire.

11. La structure (100) MEMS selon l'une quelconque des revendications précédentes, dans laquelle la deuxième structure (150) de fixation de niveau comprend une couche (157) intermédiaire au sein de la deuxième couche (152) structurée d'oxyde, et dans laquelle une surface latérale intérieure de la deuxième couche (152) structurée d'oxyde est conique en direction de la couche (157) intermédiaire.

12. La structure (100) MEMS selon l'une quelconque des revendications précédentes, dans laquelle la deuxième structure (150) de fixation de niveau comprend en outre une quatrième couche (153) conique structurée ayant une région (155) conique de bord entre la structure (110) de plaque arrière et la deuxième couche (152) structurée d'oxyde.

13. La structure (100) MEMS selon la revendication 12, dans laquelle la région (155) conique de bord de la quatrième couche (153) conique structurée commence à ou latéralement après le bord (156) de la deuxième couche (152) structurée d'oxyde.

14. La structure (100) MEMS selon l'une quelconque des revendications précédentes, dans laquelle une région centrale exposée de la structure (130) de membrane forme une région pouvant fléchir de la structure (130) de membrane.

15. La structure (100) MEMS selon l'une quelconque des revendications précédentes, dans laquelle la structure (100) MEMS est un transducteur sonique ayant une seule plaque (110) arrière.

16. La structure (100) MEMS selon l'une quelconque des revendications précédentes, dans laquelle la structure MEMS est un microphone ayant une seule plaque arrière.

17. La structure (100) MEMS selon l'une quelconque des revendications précédentes, dans laquelle la structure (130) de membrane comprend une région de bord ayant une ondulation, qui est dirigée sur la structure (120) de support.

18. La structure (100) MEMS selon l'une quelconque des revendications précédentes, dans laquelle la deuxième couche (152) structurée d'oxyde a une épaisseur dans une plage de 0,5 µm et 5,0 µm et la couche (154) conique structurée a une épaisseur dans une plage de 0,05 µm et 0,5 µm.
